# EUROPEAN PATENT APPLICATION

(11) **EP 4 653 925 A1**
(43) Date of publication of application: **26.11.2025**
(21) Application number: 24744607.3
(22) Date of filing: 15.01.2024
(51) Int. Cl.: G02B 5/22, C09B 7/00, C09B 33/048, C09B 45/22, C09B 47/04, C09B 48/00, C09B 67/46, G09F 9/30, H10K 50/85, H10K 59/38

(54) **FILM, AND SHEET AND OPTICAL DEVICE HAVING SAID FILM**

(30) Priority: 16.01.2023 JP 2023004260
(71) Applicant: Toray Industries, Inc., Tokyo 103-8666 (JP)
(72) Inventor: ISHIZUKA, Masatoshi, Otsu-shi, Shiga 520-8558 (JP)
(74) Representative: Mewburn Ellis LLP
(86) International application number: PCT/JP2024/000749
(87) International publication number: WO 2024/154684

(57) **Abstract**

An object is to provide a film that can achieve red color with high color purity and color vividness, and in a preferred aspect, also has good color purity and color vividness in the green and blue wavelength regions, and has excellent visibility. The main object is to obtain a film having a thickness of 0.2 µm to 1,000 µm, comprising a composition containing: a coloring agent (hereinafter referred to as a "light-blocking coloring agent A") characterized in that, when a film is formed on a glass substrate in a film thickness of 1 µm using transparent acrylic resin as a binder and at coloring agent concentration of 50% by weight, the average light transmittance of the film in the wavelength range of 660 nm to 1000 nm is 30% or more and the average light transmittance of the film in the wavelength range of 380 nm or more and less than 660 nm is 20% or less; a red coloring agent; and a binder, wherein the film has T1 (%) of 25% to 90%, where T1 (%) is an average value of light transmittance at wavelengths from 400 nm to 660 nm.

## Description

### Technical Field

The present invention relates to a film containing a light-blocking coloring agent suitable for use in display devices.

### Background Art

Patent Literature 1 describes an invention of a composition for use in a color filter to be placed in front of a display in which red, green, and blue pixels of an organic electro-luminescing display device are formed. The invention described in Patent Literature 1 relates to a gray photosensitive resin composition that contains one or more of a red pigment, a green pigment, and a blue pigment, and a black pigment such as carbon black, wherein the content of the black pigment is 0.5 to 10 wt% based on the total weight of the solids in the color material.

In addition, the invention described in Patent Literature 1 has the characteristic that when a cured film with a thickness of 2.5 µm is formed, the light transmittance at wavelengths from 580 nm to 620 nm is 20% or more and less than 75%, and the transmission spectrum having peak in that wavelength range (see FIG. 1 in Patent Literature 1), and also has the characteristic that the light transmittance at the wavelengths from 460 nm to 530 nm is 30% or more and less than 75%.

### Citation List

### Patent Literature

Patent Literature 1: JP 6647238 B

### Summary of Invention

### Technical Problem

However, because the cured film formed of the composition of Patent Literature 1 has a higher light transmittance in the red wavelength range of 580 nm to 620 nm, which is a red wavelength region of low color purity, than the light transmittance in the wavelength range of 640 nm to 660 nm, which is a red wavelength range with high color purity (see FIG. 1 in Patent Literature 1), resulting in a problem of a significant decrease in color vividness of red pixels.

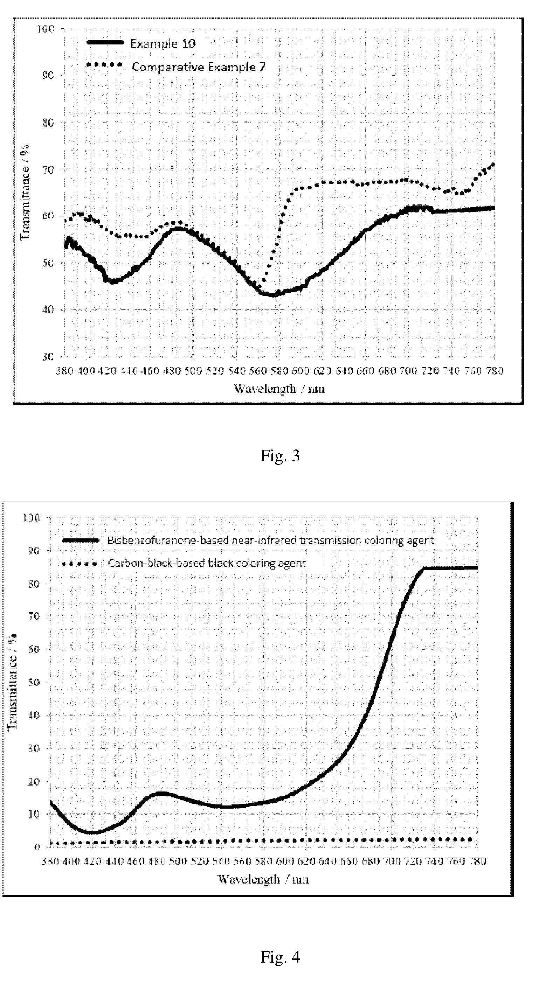

Although a black pigment such as carbon black contained in the composition of Patent Literature 1 is effective in absorbing external light and reducing the reflection of the external light on the film surface, they absorb all visible light in the wide range including wavelengths from 640 nm to 660 nm and in the near-infrared wavelength region (see FIG. 4). Therefore, when the content of black pigment is increased excessively, the red, blue, and green pixels all become darker, resulting in a problem of significant reduction in visibility.

Furthermore, although the cured film formed of the composition of Patent Literature 1 has a light transmittance of 30% or more and less than 75% at wavelengths from 460 nm to 530 nm, it is not significantly different from the light transmittance at wavelengths from 420 nm to 440 nm, and exhibits a nearly plateau transmission spectrum even within the wavelength range from 460 nm to 530 nm (see FIG. 1 of Patent Literature 1), which poses the problem of reduced color vividness for blue pixels at a wavelength of 460 nm and green pixels at a wavelength of 530 nm.

The present invention was made in consideration of these problems, and an object thereof is to provide a film that can achieve red color with high color purity and color vividness, and in a preferred aspect, also has good color purity and color vividness in the green and blue wavelength regions, and has excellent visibility when used for an optical device.

Another object is to provide a film which reduces the influence of external light when used for an optical device and, in a preferred embodiment, is useful for color tuning of light emitted from the optical device.

### Solution to Problem

The gist of the present invention to solve the above problem is as follows.
[1] A film having a thickness of 0.2 µm to 1,000 µm, including a composition containing
   a coloring agent characterized in that, when a film is formed on a glass substrate in a film thickness of 1 µm using transparent acrylic resin as a binder at coloring agent concentration of 50% by weight, the average light transmittance of the film in the wavelength range of 660 nm to 1000 nm is 30% or more and the average light transmittance of the film in the wavelength range of 380 nm or more and less than 660 nm is 20% or less;
      a red coloring agent; and
      a binder,
   wherein the film has T1 (%) of 25% to 90%, where T1 (%) is an average value of light transmittance at wavelengths from 400 nm to 660 nm.
[2] The film according to [1], further including a coloring agent having an absorption in a visible light region (this coloring agent is referred to as a "second coloring agent") as a coloring agent that does not fall under the light-blocking coloring agent A and red pigment.
[3] The film according to [2], wherein the second coloring agent is at least one selected from the group consisting of a yellow coloring agent and a blue coloring agent.
[4] The film according to [3], wherein the film contains both the yellow coloring agent and the blue coloring agent as the second coloring agent.
[5] The film according to any one of [1] to [4], wherein all or part of the light-blocking coloring agent A is a compound selected from the group consisting of azomethine compounds, perylene compounds, bisbenzofuranone compounds, and azo compounds.
[6] The film according to any one of [1] to [5], wherein a content of the light-blocking coloring agent A is 15 wt% to 44 wt%, taking the total amount of the coloring agents contained in the film as 100 wt%.
[7] The film according to any one of [1] to [6], further including a violet coloring agent.
[8] The film according to [7], wherein a content of the violet coloring agent is 1 wt% to 10 wt%, taking the total amount of the coloring agents contained in the film as 100 wt%.
[9] The film according to any one of [1] to [8], wherein T2 - T3 is 3% or more, where T2 (%) is an average value of light transmittance at wavelengths from 640 nm to 660 nm, and T3 (%) is an average value of light transmittance at wavelengths from 580 nm to 620 nm.
[10] The film according to any one of [1] to [9], wherein T4 - T5 is 3% or more, where T4 (%) is an average value of light transmittance at wavelengths from 460 nm to 480 nm, and T5 (%) is an average value of light transmittance at wavelengths from 420 nm to 440 nm.
[11] The film according to any one of [1] to [10], wherein a color difference is within 6%, where the color difference is defined as the larger one, of the absolute value of the difference between the maximum value and average value of light transmittance, and the absolute value of the difference between the average value and minimum value of light transmittance, at wavelengths of 460 nm, 530 nm, and 640 nm.
[12] The film according to any one of [1] to [11], wherein the film has adhesiveness.
[13] A sheet comprising a substrate, and the film according to any one of [1] to [12].
[14] The sheet according to [13], wherein chromaticity (a*, b*) of a reflected light or transmitted light according to the SCI method when measured using a D65 light source as a light source is -10 ≤ a* ≤ 10 and -10 ≤ b* ≤ 10.
[15] The sheet according to [13], wherein chromaticity (a*, b*) of a reflected light or transmitted light according to the SCI method when measured using an A light source as a light source is -10 ≤ a* ≤ 10 and -10 ≤ b* ≤ 10.
[16] An optical device including a light source, and a sheet having the film according to any one of [1] to [12] provided on a substrate, wherein the chromaticity (a*, b*) of transmitted light or reflected light of light incident from the light source toward the sheet is -10 ≤ a* ≤ 10 and -10 ≤ b* ≤ 10.

### Advantageous Effects of Invention

The film of the present invention can achieve red color with high color purity and color vividness. In a preferred aspect, a film can be provided which also has good color purity and color vividness in the green and blue wavelength regions, and has excellent visibility, when used as a material for an optical device.

The film of the present invention reduces the influence of external light when used for an optical device and, in a preferred embodiment, is useful for color tuning of light emitted from the optical device.

### Brief Description of Drawings

FIG. 1 is a cross-sectional view of an example of a film of the present invention.
FIG. 2 is a cross-sectional view of an example of a sheet including a film of the present invention formed on a substrate.
FIG. 3 shows a transmission spectrum of films prepared in Example 10 and Comparative Example 7.
FIG. 4 is an example of a transmission spectrum that compares a film containing as a coloring agent, only a bisbenzofuranone-based compound, which is one of the light-blocking coloring agents A, with a film containing only a carbon black pigment, which does not fall under the light-blocking coloring agents A.
FIG. 5 is another example of the film of the present invention, and is a cross-sectional view of a film composed of a plurality of layers.
FIG. 6 is another example of a sheet having a film of the present invention formed on a substrate; FIG. 6(a) is a cross-sectional view of an example where another layer is formed between the film of the present invention and the substrate; FIG. 6(b) is a cross-sectional view of an example where another layer is formed on the surface of the substrate opposite to the surface on which the film of the present invention is formed; and FIG. 6(c) is a cross-sectional view of an example where another layer is formed on the film of the present invention formed on the substrate.
FIG. 7 is a cross-sectional view of an example where the film of the present invention is laminated on a display which corresponds to a light source and a substrate.
FIG. 8 is a cross-sectional view for explaining the light path when a light beam is irradiated from the surface side on which the film of the present invention is formed in a sheet having the film of the present invention formed on an opaque substrate.
FIG. 9 is a cross-sectional view for explaining the light path when a light beam is irradiated from the surface side opposite to the surface on which the film of the present invention is formed in a sheet having the film of the present invention formed on a transparent substrate.
FIG. 10 is a cross-sectional view for explaining the light path when a light beam is irradiated from the surface side on which a transparent substrate of a laminate is formed, the laminate including a reflection film, the film of the present invention, and the transparent substrate, laminated in this order.

### Description of Embodiments

The present invention relates to a film having a thickness of 0.2 µm to 1,000 µm, including a composition containing:
a coloring agent (light-blocking coloring agent A) characterized in that, when a film is formed on a glass substrate in a film thickness of 1 µm using transparent acrylic resin as a binder and at coloring agent concentration of 50% by weight, the average light transmittance of the film in the wavelength range of 660 nm to 1000 nm is 30% or more and the average light transmittance of the film in the wavelength range of 380 nm or more and less than 660 nm is 20% or less;
a red coloring agent; and
a binder,
wherein the film has T1 (%) of 25% to 90%, where T1 (%) is an average value of light transmittance at wavelengths from 400 nm to 660 nm.

Preferably, the coloring agent other than the above-mentioned light-blocking coloring agent A and having absorption in a visible light region is at least one selected from the red coloring agent, the yellow coloring agent and the blue coloring agent. Among them, the red coloring agent is to be used. When the red coloring agent is used, coloring agents other than the red coloring agent may be used in combination, and such coloring agents are not limited to the yellow coloring agent and the blue coloring agent.

In addition, using the red coloring agent, the yellow coloring agent and the blue coloring agent in combination is a preferred aspect.

First, a typical example, a film including a red coloring agent, a yellow coloring agent, and the blue coloring agent, along with a light-blocking coloring agent A, will be illustrated with reference to drawings.

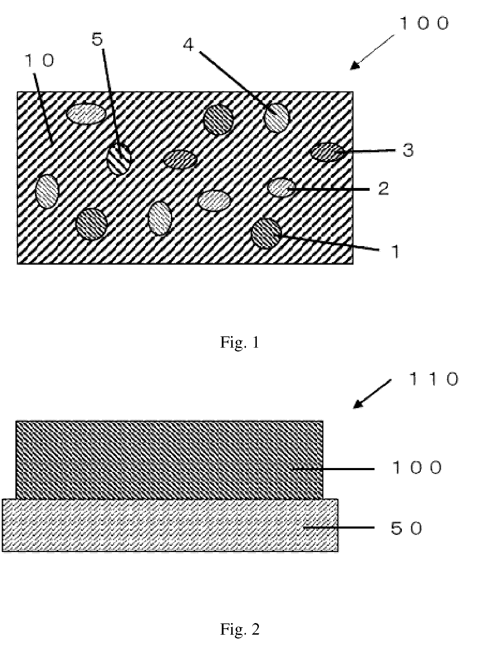

FIG. 1 is a cross-sectional view showing an example of a film of the present invention. The film shown in FIG. 1 contains a red coloring agent 2, a yellow coloring agent 3, a blue coloring agent 4, a light-blocking coloring agent A1, and a binder 10. The film of the present invention has a T1 (%) of 25% to 90%, where T1 (%) is an average value of light transmittance at wavelengths from 400 to 660 nm, and a thickness of 0.2 µm to 1,000 µm.

The light transmittance T1 of the film, and T2 to T5, as described below, are obtained from the transmission spectra of the film, measured in the measurement wavelength range from 380 nm to 780 nm, using a microspectrophotometer "LCF-100MA" MCPD9800 spectrometer 3683C manufactured by Otsuka Electronics Co., Ltd., every 1 nm, by setting an exposure time to 30 msec, an accumulation count to 4, sensitivity to Normal, chromaticity (C light source).

When measuring the light transmittance of the film formed on the substrate, the light transmittance of the film itself can be obtained by performing a base correction using only the substrate alone as a reference and then measuring the laminate of the substrate and the film of the present invention. The same applies when the substrate uses multiple materials or even when materials other than the substrate are laminated.

The light-blocking coloring agent A used in the present invention refers to a material having a transmission function with an average value of light transmittance in a near-infrared wavelength region from 660 nm to 1,000 nm of 30% or more, and a light-blocking function with an average value of light transmittance in a visible light wavelength region less than 660 nm of 20% or less, for a film containing only the light-blocking coloring agent A itself as a coloring agent and having the content of colorant in the film of 50 wt%, taking the total amount of the film as 100 wt%, and formed on a glass substrate at a film thickness of 1 µm, that is, a coloring agent which is also referred to as a near-infrared transmission coloring agent, more specifically, a material, when the film is formed on a glass substrate at a film thickness of 1 µm, using a transparent acrylic resin as a binder, with a concentration of 50 wt%, shows an average value of light transmittance of the film at wavelengths from 660 nm to 1,000 nm of 30% or more and an average value of light transmittance of the film at wavelengths from 380 nm or more and less than 660 nm of 20% or less.

Such materials are known to be used as near-infrared filter materials. The light-blocking coloring agent A has transmissiveness in the near-infrared region (660 nm to 1,000 nm), and therefore has different transmission characteristics from carbon black which is commonly used as a light-blocking material (see FIG. 4). The light-blocking coloring agent A used in the present invention preferably has a property of exhibiting a steep increase in transmittance at wavelengths from 660 nm to 720 nm.

In this case, the transparent acrylic resin is an acrylic or methacrylic resin that has a light transmittance of 99% or more over the entire wavelength region of 300 nm or more and less than 1,000 nm when a film having a thickness of 1 µm is formed on glass. An example of such a resin is a copolymer of benzyl methacrylate/methacrylic acid=70/30 (molar ratio) having a weight-average molecular weight in terms of polystyrene of 30,000.

The light-blocking coloring agent A used in the present invention is not particularly limited as long as it falls under the above-mentioned definition, but is preferably selected from the group consisting of azomethine compounds, perylene compounds, bisbenzofuranone compounds, and azo compounds.

Examples of the azomethine compounds include compounds described in JP-H1-170601 A, JP-H2-34664 A, etc. For example, "Chromofine black A1103" manufactured by Dainichiseika Color & Chemicals Mfg. Co., Ltd. is commercially available. Examples of the perylene compounds include C.I. Pigment Black 21, 30, 31, 32, 33, 34. Examples of the bisbenzofuranone compounds include compounds described in JP 2010-534726 W, JP 2012-515233 W, JP 2012-515234 W, etc. For example, "Irgaphor Black" manufactured by BASF is commercially available.

The film of the present invention takes advantage of the characteristics of the light-blocking coloring agent A to suppress the light transmittance in the wavelength range from 580 nm to 620 nm, while not suppressing the transmission of light in the wavelength range from 640 nm to 660 nm, which exhibits the red color with high color purity, and therefore can improve the color purity when used in combination with the red coloring agent. When used in combination with the blue coloring agent, it is possible to selectively suppress the light transmittance at wavelengths from 420 nm to 440 nm, which presents blue color with lower color purity, without significantly reducing the light transmittance at wavelengths from 460 nm to 480 nm, which presents blue color with higher color purity, compared to when used in combination with a conventional black pigment such as carbon black. In addition, it becomes easier to suppress the influence of the entrance of external light, such as the phenomenon of color being exhibited in association with incidence and emission of external light.

Taking the total weight of the film as 100%, the content of all coloring agents contained in the film of the present invention is preferably 60 wt% or less, and more preferably 50 wt% or less to maintain the dispersion stability of the coloring agents, and is preferably 0.01 wt% or more, and more preferably 0.04 wt% or more from the viewpoint of maintaining the color density of each coloring agent. The content of the light-blocking coloring agent A contained in the film of the present invention is preferably from 15 to 45 wt%, and even more preferably from 15 to 44 wt%, taking the total amount of the coloring agents as 100 wt%. The total amount of coloring agents used herein means the total amount of all coloring agents in the film, not only the light-blocking coloring agent A, but also the red coloring agent, the yellow coloring agent, the blue coloring agent, etc. By setting the content of the light-blocking coloring agent A to 15 wt% or more, the light transmittance in the wavelength range from 580 nm to 620 nm is suppressed, while the light transmittance in the wavelength range from 640 nm to 660 nm, which presents red color with high color purity, is not suppressed, and the light transmittance in the wavelength range from 420 nm to 440 nm, which presents blue color with low color purity can be selectively suppressed, without significantly reducing the light transmittance in the wavelength range from 460 nm to 480 nm, which presents blue color with high color purity. It can also suppress the influence of the penetration of external light at the same time, which is preferable. The content of the light-blocking coloring agent A set to 44 wt% or less is preferred because it allows the average value of the light transmittance of the film to be 25% or more in the visible light region and prevents the screen from becoming darker.

For the purpose of the color tuning, the film may contain, in addition to the light-blocking coloring agent A, the red coloring agent or a coloring agent having absorption in the visible light region, other than the red coloring agent (such coloring agent may be referred to as a "second coloring agent" for convenience). The use of such coloring agents increases the freedom for color design, and when used for an optical device such as a display device, as described below, the color can be determined taking into account the spectrum of the light source and the reflection and absorption of light in the substrate such as a base film, making it easier to achieve highly chromatic colors or colors that are closer to the achromatic color. Such a second coloring agent may be either a dye or a pigment, but is desirably a pigment from the viewpoint of heat resistance and weather resistance.

As the second coloring agent, any coloring agent of any color can be employed depending on the required color. For the film of the present invention, it is advantageous from the viewpoint of color tuning that the second coloring agent is at least one coloring agent selected from the group consisting of the yellow coloring agent and the blue coloring agent. It is also preferable to use both the yellow coloring agent and the blue coloring agent together with the red coloring agent for greater degree of freedom for the color tuning. For example, the inclusion of the above-mentioned red coloring agent, yellow coloring agent, and blue coloring agent in the film of the present invention facilitates the color tuning by adjusting their types and amounts, reducing the color difference between red, green, and blue, or achieving more neutral color.

Examples of the red coloring agent include C.I. Pigment Red 9, 48, 97, 122, 123, 144, 149, 166, 168, 177, 179, 180, 192, 209, 215, 216, 217, 220, 223, 224, 226, 227, 228, 240, 254, 255, 256, 257, 258, 260, 261, 264, 266, 267, 268, 269, 273, 274, 291; C.I. Solvent Red 45, 49, 125, 130; C.I. Acid Red 1, 4, 8, 14, 17, 18, 26, 27, 29, 31, 34, 35, 37, 42, 44, 50, 51, 52, 57, 66, 73, 80, 87, 88, 91, 92, 94, 97, 103, 111, 114, 129, 133, 134, 138, 143, 145, 150, 151, 158, 176, 182, 183, 195, 198, 206, 211, 215, 216, 217, 227, 228, 249, 252, 257, 258, 260, 261, 266, 268, 270, 274, 277, 280, 281, 308, 312, 315, 316, 339, 341, 345, 346, 349, 382, 383, 394, 401, 412, 417, 418, 422, 426; C.I. Direct Red 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246, 250; and C.I. Mordant Red 1, 2, 3, 4, 9, 11, 12, 14, 17, 18, 19, 22, 23, 24, 25, 26, 30, 32, 33, 36, 37, 38, 39, 41, 43, 45, 46, 48, 53, 56, 63, 71, 74, 85, 86, 88, 90, 94, 95.

Examples of the yellow coloring agent include C.I. Pigment Yellow 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75, 81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, 211, 213, 218, 220, 221, 228; C.I. Solvent Yellow 5, 162; C.I. Acid Yellow 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243, 251; and C.I. Direct Yellow 2, 33, 34, 35, 38, 39, 43, 47, 50, 54, 58, 68, 69, 70, 71, 86, 93, 94, 95, 98, 102, 108, 109, 129, 136, 138, 141; C.I. Mordant Yellow 5, 8, 10, 16, 20, 26, 30, 31, 33, 42, 43, 45, 56, 61, 62, 63.

Examples of the blue coloring agent include C.I. Pigment blue 1, 1:2, 9, 14, 15, 15:1, 15:2, 15:3, 15:4, 15:5, 15:6, 16, 17, 19, 25, 27, 28, 29, 33, 35, 36, 56, 56:1, 60, 61, 61:1, 62, 63, 64, 66, 67, 68, 71, 72, 73, 74, 75, 76, 78, 79 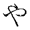 C.I. Solvent Blue 5, 25, 35, 38, 44, 45, 64, 67, 70, 122, 129; C.I. Acid Blue 7, 23, 25, 27, 35, 40, 41, 43, 45, 47, 49, 51, 53, 55, 56, 62, 68, 69, 78, 80, 81:1, 90, 104, 111, 112, 124, 127, 127:1, 138, 140, 150, 175, 215, 230, 244, 277, 344; C.I. Direct Blue 86, 87, 199; C.I. Reactive Blue 25; and C.I. Mordant Blue 1, 3, 17, 29.

In addition, the film of the present invention preferably contains the violet coloring agent as the second coloring agent. The inclusion of the light-blocking coloring agent A in the film of the present invention suppresses the light transmittance at the visible light wavelengths. In addition, the inclusion of the violet coloring agent in the film of the present invention makes the light transmittance at wavelengths from 460 nm to 480 nm, which presents blue color with high color purity, and the light transmittance at wavelengths from 640 nm to 660 nm, which presents red color with high color purity, relatively higher compared to a case where the concentration of the color material in the solid content of the film is the same, but the violet coloring agent is not contained, and as a result, the color purity can be selectively enhanced.

Examples of the violet coloring agent include C.I. Pigment Violet 14, 19, 23, 29, 30, 32, 33, 36, 37, 40, 50; C.I. Solvent Violet 2, 8, 9, 11, 13, 14; C.I. Acid violet 6B, 7, 9, 17, 19; C.I. Direct Violet 47, 52, 54, 59, 60, 65, 66, 79, 80, 81, 82, 84, 89, 90, 93, 95, 96, 103, 104; and C.I. Mordant Violet 1, 2, 4, 5, 7, 14, 22, 24, 30, 31, 32, 37, 40, 41, 44, 45, 47, 48, 53, 58.

The content of the violet coloring agent contained in the film of the present invention is not particularly limited, but is preferably 1 wt% to 10 wt%, taking the total amount of the coloring agents as 100 wt%. The content of the violet coloring agent of 1 wt% or more will not reduce the light transmittance at wavelengths from 640 nm to 660 nm, and the content of the violet coloring agent of 10% or less can suppress the reduction in the light transmittance at wavelengths around 460 nm.

Examples of the second coloring agent that can be used in the present invention, other than the yellow coloring agent and blue coloring agent, include green coloring agents such as C.I. Pigment Green 7, 36, 58, 59, 62, 63; C.I. Solvent Green 1, 3, 4, 5, 7, 28, 29, 32, 33, 34, 35; C.I. Acid green 1, 3, 5, 6, 7, 8, 9, 11, 13, 14, 15, 16, 22, 25, 27, 28, 41, 50, 50:1, 58, 63, 65, 80, 104, 105, 106, 109; C.I. Direct Green 25, 27, 31, 32, 34, 37, 63, 65, 66, 67, 68, 69, 72, 77, 79, 82, and C.I. Mordant Green 1, 3, 4, 5, 10, 13, 15, 19, 21, 23, 26, 29, 31, 33, 34, 35, 41, 43, 53; orange coloring agents such as C.I. Pigment Orange 13, 36, 38, 43, 51, 55, 59, 61, 64, 65, 71; and brown coloring agents such as C.I. Pigment Brown 28.

The film of the present invention contains a binder, which acts to retain the coloring agents and other components described above. Note that the binder used for the film of the present invention does not have to be a transparent acrylic resin. The material for the binder is not particularly limited, and may be a binder resin composed of natural resin or synthetic resin, or ceramic such as alumina, or the like. Examples of the binder resin include acrylic resins, epoxy-based resins, polyimide-based resins, urethane-based resins, urea-based resins, vinyl-based resins, melamine-based resins, polyamide-based resins, polyester-based resins, olefin-based resins, and cellulose-based resins. Two or more of these resins may be contained. When the binder is opaque, it may affect the light transmission characteristics and reflection characteristics of the film of the present invention. Therefore, it is preferable to use a transparent one. When the binder itself is colored, it may affect the color. Therefore, it is preferable to use an achromatic color. That is, a colorless and transparent material is preferably used.

In addition, for the film of the present invention, it is preferable to use a binder made of resin from the viewpoint of handling properties during preparation and flexibility of the resulting film, and acrylic resin is preferable from the viewpoint of dispersibility and stability over time. Examples of the acrylic resin include a polymer of an unsaturated carboxylic acid and a copolymer of an unsaturated carboxylic acid and another ethylenically unsaturated compound. Among them, a copolymer of an unsaturated carboxylic acid and an ethylenically unsaturated compound is preferred. Examples of the unsaturated carboxylic acid include acrylic acid, methacrylic acid, itaconic acid, crotonic acid, maleic acid, fumaric acid, and vinyl acetate.

Examples of the ethylenically unsaturated compound include unsaturated carboxylic acid alkyl ester such as methyl acrylate, methyl methacrylate, ethyl acrylate, ethyl methacrylate, benzyl methacrylate; aromatic vinyl compounds such as styrene and methylstyrene; unsaturated carboxylic acid aminoalkyl ester such as aminoethyl acrylate; unsaturated carboxylic acid glycidyl ester such as glycidyl acrylate, and glycidyl methacrylate; carboxylic acid vinyl ester such as vinyl acetate and vinyl propionate; vinyl cyanide compounds such as acrylonitrile, methacrylonitrile, and α-chloroacrylonitrile; aliphatic conjugated diene such as 1,3-butadiene and isoprene; macromonomers such as polystyrene having an acryloyl group or methacryloyl group at the end, polymethyl acrylate, polymethyl methacrylate, polybutyl acrylate, polybutyl methacrylate, and polysilicone.

The acrylic resin preferably has an ethylenically unsaturated group in the side chain, which can improve sensitivity when the resin has photosensitivity. Examples of the ethylenically unsaturated group include a vinyl group, an allyl groups, an acrylic group, and a methacrylic group. Examples of the method of introducing the ethylenically unsaturated group into the side chain of the acrylic resin include a method of subjecting an acrylic resin to an addition reaction with an ethylenically unsaturated compound, acrylic acid chloride, methacrylic acid chloride, or the like having an epoxy group when the acrylic resin has a carboxyl group, a hydroxyl group, or the like; and a method of adding a compound having an ethylenically unsaturated group using isocyanate.

Examples of the acrylic resin having an ethylenically unsaturated group in the side chain include "CYCLOMER" (registered trademark) P(ACA)Z250 manufactured by DAICEL-ALLNEX LTD. (45 wt% solution of dipropylene glycol monomethyl ether), "ADEKA ARKLS" WR301 manufactured by ADEKA CORPORATION (45 wt% solution of dipropylene glycol monomethyl ether), KRX-3802 (45 wt% solution of dipropylene glycol monomethyl ether), and alkali soluble cardo resins.

When the binder is a resin, the weight-average molecular weight (Mw) of the resin is preferably 3,000 or more, and more preferably 5,000 or more, from the viewpoint of improving the strength of the film. On the other hand, it is preferably 200,000 or less, and more preferably 100,000 or less, from the viewpoint of improving the stability of the film. The weight-average molecular weight is a value measured by gel permeation chromatography and determined in terms of standard polystyrene.

Taking the total weight of the film as 100 wt%, the content of binder in the film of the present invention is preferably 0.5 wt% or more, and more preferably 1 wt% or more from the viewpoint of maintaining the mechanical strength of the film, and is preferably 99.99 wt% or less, and more preferably 99.96 wt% or less from the viewpoint of maintaining the color density of each coloring agent.

The composition for obtaining the film of the present invention may contain, as a component other than the light-blocking coloring agent A, the red coloring agent, the binder, and the second coloring agent, an adhesion improver, a surfactant, a dispersant, a reactive monomer, a photopolymerization initiator, a chain transfer agent, a sensitizer, a polymerization inhibitor, etc., and may contain two or more of them. Examples of the adhesion improver include silane coupling agents such as 3-methacryloxypropyltrimethoxysilane and 3-acryloxypropyltrimethoxysilane. The content of the adhesion improver is preferably 0.001 wt% or more and 10 wt% or less, taking the total amount of the binder as 100 wt%.

Examples of the surfactant include anionic surfactants, cationic surfactants, amphoteric surfactants, nonionic surfactants, fluorine-based surfactants, and silicon-based surfactants. The inclusion of the surfactant can improve the surface smoothness of the resulting film. The content of the surfactant is preferably 0.01 wt% or more and 10 wt% or less, taking the total amount of the film as 100 wt%.

The dispersant preferably has a coloring agent affinity moiety that has a property of adsorbing to the coloring agent and a moiety that is compatible with the substance carrying the coloring agent in the film, and those having functions to adsorb to the coloring agent and to stabilize dispersion in the coloring agent carrier are preferred. Examples of the commercially available dispersant include DisperBYK manufactured by BYK Japan, SOLSPERSE manufactured by Lubrizol Japan Limited, EFKA and Efka manufactured by BASF, and AJISPER manufactured by Ajinomoto Fine-Techno Co., Inc. The content of the dispersant is preferably 0.01 wt% or more and 10 wt% or less, taking the total weight of the entire film obtained as 100 wt%.

Furthermore, a composition (precursor composition) for obtaining the film of the present invention may contain a compound such as a reactive monomer and a photopolymerization initiator, the compound giving a polymer as a binder upon irradiation with light, and the precursor composition may further contain a chain transfer agent, a sensitizer, and a chain transfer agent.

Examples of the reactive monomer include oligomer such as bisphenol A diglycidyl ether (meth)acrylate, poly(meth)acrylate carbamate, and alkyd-modified (meth)acrylate, tripropylene glycol di(meth)acrylate, pentaerythritol tetra(meth)acrylate, dipentaerythritol hexa(meth)acrylate, dipentaerythritol penta(meth)acrylate, and alkyl modified product, alkyl ether modified product, and alkyl ester modified product thereof. The molecular weight of the reactive monomer is preferably 400 or more from the viewpoint of compatibility with the binder. The content of the reactive monomer in the composition for obtaining the film of the present invention is preferably 10 wt% or more and 80 wt% or less, taking the total amount of the entire binder as 100 wt%.

Examples of the photopolymerization initiator include benzophenone-based compound, alkylphenone-based compounds, anthraquinone-based compounds, imidazole-based compounds, benzothiazole-based compounds, benzoxazole-based compounds, oxime ester compounds, triazine-based compounds, phosphorus-based compounds, and titanates. The content of the photopolymerization initiator in the precursor composition is preferably 0.1 wt% or more and preferably 10 wt% or less, taking the total amount of the entire binder as 100 wt%.

Examples of the chain transfer agent include mercapto compounds such as thioglycolic acid, thiomalic acid, thiosalicylic acid, 2-mercaptopropionic acid, 3-mercaptopropionic acid, 3-mercaptobutyric acid, mercaptoacetic acid, trimethylolpropane tris, pentaerythritol tetrakis, 1,4-bis(3-mercaptobutyryloxy)butane; disulfide compounds obtained by oxidizing the mercapto compounds; and iodized alkyl compounds such as iodoacetic acid and iodopropionic acid. The content of the chain transfer agent in the precursor composition is preferably 0.01 wt% or more and 10 wt% or less, taking the total amount of the entire binder as 100 wt%.

Examples of the sensitizer include thioxanthone-based sensitizers, and aromatic or aliphatic tertiary amines. The content of the sensitizer in the precursor composition is preferably 0.01 wt% or more and 5 wt% or less, taking the total amount of the entire binder as 100 wt%. Examples of the polymerization inhibitor include hydroquinone, tert-butylhydroquinone, 2,5-bis(1,1,3,3-tetramethylbutyl)hydroquinone, catechol, and tert-butylcatechol. The content of the polymerization inhibitor in the precursor composition is preferably 0.001 wt% or more and 5 wt% or less, taking the total amount of the binder as 100 wt%.

The film of the present invention is characterized in that T1(%) is 25% to 90%, where T1 (%) is an average value of light transmittance at wavelengths from 400 nm to 660 nm. The light-blocking coloring agent A used in the present invention has sometimes been used in near-infrared filters, but when used in the near-infrared filters, the light transmittance in the visible light region is almost always designed to be close to zero, and there has been no idea of using it in combination with other coloring agents, especially red coloring agents, to enhance the color purity, nor has there been any idea of using the film of the present invention as a component of display pixels, which are less susceptible to the influence of external light and also have a role of color tuning.

Specifically, when T1 (%) of the film is 25% or more, the bare minimum amount of visible light required for pixel display can be transmitted and the screen can be prevented from becoming dark. Furthermore, when T1 (%) is 90% or less, the influence of external light that impedes pixel display can be minimized, and the screen can be prevented from becoming difficult to view due to external light. In addition, it is preferable that T1 (%) be set to 35% to 80%, because the screen can be brightened to improve visibility, and the adverse influence of external light can be better prevented.

It is theoretically possible to increase T1 (%) to 25% or more even for a conventional composition which contains a high percentage of the light-blocking coloring agent A, when the thickness of the film formed by the composition is extremely thin, but in that case another problem arises. The present invention is also of technical significance in that the thickness of the film is set to 0.2 µm to 1,000 µm to prevent such problems from occurring.

In other words, by setting the film thickness to 0.2 µm or more, the occurrence of defects such as pinholes upon formation of the film can be reduced. Furthermore, by setting the film thickness to 1,000 µm or less, even when the content of the coloring agent other than the light-blocking coloring agent A is minutely small, i.e., even when the concentration is low, the variation in content ratio, i.e., concentration unevenness, upon formation of the film of the present invention can be reduced, making it easier to adjust T1 (%) within the above-mentioned range and to adjust the color balance. Furthermore, in order to improve the mechanical strength of the film and facilitate the color balance adjustment, the film thickness of the present invention is preferably 0.4 µm to 200 µm.

In the film of the present invention, T2 - T3 is preferably 3% or more, where T2 (%) is an average value of light transmittance at wavelengths from 640 nm to 660 nm, and T3 (%) is an average value of light transmittance at wavelengths from 580 nm to 620 nm. T2 - T3 of 3% or more for the film of the present invention has the effect of significantly improving the color vividness of the red pixel. For further improvement of the color vividness of the red pixel, it is more preferable that T2 - T3 for the film of the present invention be 5% or more. The larger T2 - T3 is more preferable. To explain this using the example of bisbenzofuranone, an example of the light-blocking coloring agent A, it can be seen that the slope of the spectrum of the film near the relevant wavelength (580 nm to 660 nm) increases, reflecting the upward-slope of the spectrum on the longer wavelength side (see FIG. 4). In view of these examples, it is preferable to set the upper limit of T2 - T3 to 45%, taking into consideration the difference between the light transmittances at wavelengths from 660 nm to 710 nm that can substantially maximize the upward-slope of the spectrum of the light-blocking coloring agent A (light transmittance at 710 nm - light transmittance at 660 nm).

In the film of the present invention, T4 - T5 is preferably 3% or more, where T4 (%) is an average value of light transmittance at wavelengths from 460 nm to 480 nm, and T5 (%) is an average value of light transmittance at wavelengths from 420 nm to 440 nm. T4 - T5 of 3% or more for the film of the present invention has the effect of improving the color vividness of the blue pixel. For further improvement of the color vividness of the blue pixel, it is more preferable that T4 - T5 for the film of the present invention be 5% or more. The larger T4 - T5 is more preferable. To explain a practical upper limit using the example of bisbenzofuranone, an example of the light-blocking coloring agent A, it can be seen that the practical upper limit increases, reflecting the upward-slope of the spectrum near the relevant wavelength (420 nm to 480 nm). In view of these examples, it is preferable that the upper limit of T4 - T5 be 20%, taking into consideration the difference between the light transmittances at wavelengths from 420 nm to 480 nm that can substantially maximize the upward-slope of the spectrum of the light-blocking coloring agent A (light transmittance at 480 nm - light transmittance at 420 nm).

In the film of the present invention, as for the light transmittance in the wavelengths of 460 nm, 530 nm, and 640 nm, a color difference is preferably 6% or less, where the color difference is defined as the larger one, of the absolute value of the difference between the maximum value and average value of light transmittance at these three wavelengths, and the absolute value of the difference between the average value and minimum value of light transmittance at these three wavelengths. The color difference is 6% or less enables, for example, when white light from red, green, and blue monochromatic light sources is used, each of the pure red, green, and blue wavelengths necessary for screen display to be equally transmitted, making it easy to control the color balance of red, green, and blue pixels and to suppress reduction in the color purity of each color light.

For further easier control of the color balance of pixels and further improvement of the color purity of each color of light, the color difference of 4% or less is more preferable. The smaller color difference enables adjustment of the emission intensity of each monochromatic light source of red, blue, and green to the same extent, and as a result, the color balance defects caused by different emission intensities of monochromatic light sources can be eliminated, and the color purity of each transmitted color can be improved.

In addition, the film of the present invention preferably has adhesiveness. Here, the adhesiveness refers to the sticky property. In the present invention, sample is evaluated by peel adhesion strength using a method according to JIS Z 0237:2022 (sample width: 20 mm, backing material: 25-µm thick PET film, pressure conditions: 2 kg roller, 1 reciprocating; aging conditions: 23°C/50% RH for 1 hour, test speed: 300 mm/min, test conditions: 23°C/50% RH, peel angle: 180 degrees), and the sample showing 100 gf or more is determined to have adhesiveness.

Having adhesiveness facilitates attachment to a surface of a display, etc. Examples of the method of imparting adhesiveness to the film of the present invention include a method of adding various adhesives, such as rubber-based, acrylic, and silicone-based adhesives, in an amount of 0.01 wt% or more and 20 wt% or less, taking the mass of the entire film as 100 wt%, and a method of using a material having adhesiveness as a binder.

As an adhesive, an acrylic adhesive for permanent adhesive with a high degree of cross-linking is preferred, envisaging that the adhesive is not peeled off after the film is attached to a surface of a display or the like. The binder having adhesiveness may be, for example, a photocurable urethane-based resin, which can be attached to a surface of a display or the like, and then cured by irradiation with ultraviolet light or the like for firm adhesion.

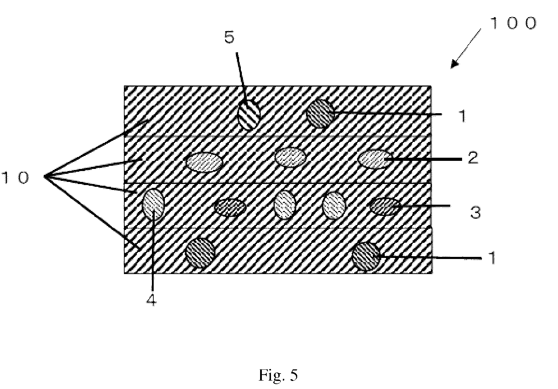

The film of the present invention may be a single-layer film or the laminated film including multiple layers, and in a case of the laminated film including multiple layers, the coloring agent to be contained may be contained in another layer. For example, the first layer contains only the light-blocking coloring agent A, the second layer contains the yellow coloring agent and the blue coloring agent, the third layer contains only the red coloring agent, and the fourth layer contains the violet coloring agent and an infrared transmission coloring agent (see FIG. 5). When the film of the present invention is the laminated film including multiple layers, the content of each coloring agent shown above is determined as the amount of each coloring agent contained in the entire laminated film, and the content ratio of each coloring agent is determined as a ratio of the content of each coloring agent to the total amount of the coloring agents contained in the entire laminated film, which is taken as 100 wt%.

The film may be used as the film alone, or as the sheet of the present invention obtained by forming the film of the present invention on another substrate. For example, as shown in FIG. 2, the film of the present invention is formed on the substrate 50 to provide the sheet 110 of the present invention. In particular, when the thickness of the film of the present invention is 50 µm or less, the film alone often lacks rigidity and is difficult to handle, so the lack of rigidity of the film is compensated for by using the substrate.

The substrate used in the sheet of the present invention may be transparent or opaque, and when the opaque substrate is used, it may be the substrate that can be peeled off later. An example of the transparent substrate is a substrate with a total light transmittance of 80% or more when measured using the method specified in JIS K 7375:2008.

When the substrate 50 is opaque and it is difficult to measure the light transmittances T1 to T5 (%) of the film of the present invention in a state where the film is combined with the substrate, a transparent substrate can be prepared separately and the composition and the film of the present invention are transferred and formed thereon and measurement is performed on the sheet after transfer, or the film of the same composition is reproduced on a transparent substrate which has been prepared separately, and then the light transmittances T1 to T5 (%) can be measured.

The material for the above-mentioned substrate is not particularly limited, and examples thereof may include, in addition to plastic films, paper, metal plates, and ceramic sheets. It may also be a substrate in which these layers are laminated.

When a plastic film is used as a material for the substrate, examples of the material include resin films such as polyester, polyvinyl chloride, polypropylene, polyethylene, acrylic, urethane, polycarbonate, polyamide, polystyrene, acrylonitrile butadiene styrene copolymer, polyvinyl alcohol, cyclo-olefin, and polyimide.

When paper is used as the material for the substrate, it may be made of cellulose or synthetic paper. When a metal plate is used as the substrate, examples thereof include steel plates, copper plates, aluminum foils, and nickel foils. When ceramic sheet is used as the material for the substrate, examples thereof include soda glass plates, alkali-free glass plates, alumina boards, zirconia sheets, aluminum nitride sheets, and silicon nitride sheets.

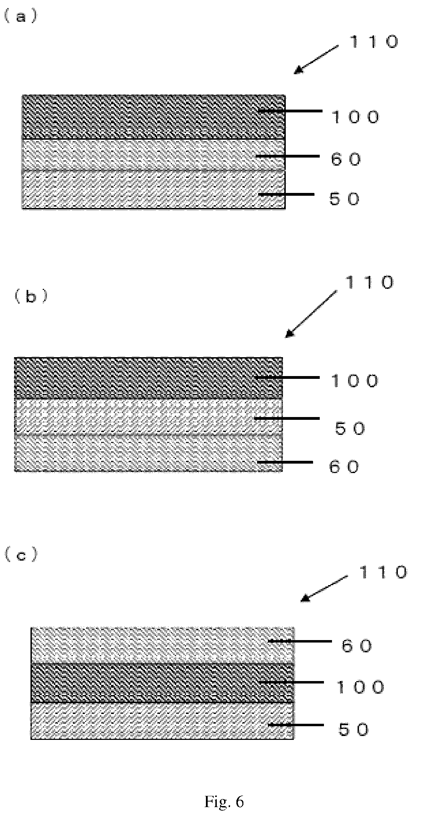

The thickness of the substrate is not particularly limited, but is preferably 10 µm or more and 2 mm or less, from the viewpoint of appropriate rigidity, bending resistance, and ease of handling. Another layer 60 may be formed between the film and the substrate (see FIG. 6(a)), or another layer 60 may be formed on a surface opposite to a surface of the substrate 50 on which the film 100 of the present invention is provided (see FIG. 6(b)). Alternatively, another layer 60 can also be formed as a layer covering the film of the present invention formed on the substrate 50 (see FIG. 6(c)).

Examples of another layer described above include a moisture vapor barrier layer to prevent deterioration of a display due to moisture and the like, an antireflection layer to prevent reflection of external light, an anchor layer to improve interlayer adhesion and the like, a UV cut layer to prevent deterioration of the coloring agent contained in the film of the present invention due to UV lights, and a hard coat layer to prevent abrasion of the film of the present invention.

Next, a method of forming the film of the present invention will be described. The method of forming the film is not particularly limited. For example, in a case of forming a thin film of less than tens of micrometers, the composition in a state of a coating fluid containing a solvent is prepared, and the composition is applied on a substrate to form a coating film, which is then dried to disperse the solvent, thereby to form the film.

The inclusion of the solvent in the composition can provide suitable viscosity characteristics for application on the substrate. Examples of the solvent include acetate-based solvents, alkylene glycol ether-based solvents, aliphatic ester-based solvents, aliphatic alcohol-based solvents, ketone-based solvents, and hydrocarbon-based solvents. Specific examples include ethyl acetate, 3-methyl-2-butanol, butanol, propylene glycol monomethyl ether, butyl acetate, propylene glycol monoethyl ether, isopentyl acetate, xylene, propylene glycol monomethyl ether acetate, and pentyl acetate.

Alternatively, the composition may be prepared using a reactive diluent in place of the aforementioned solvent, and the composition may be applied on the substrate to form the film of the present invention. Examples of the reactive diluent include short-chain aliphatic alcohols, polymeric alkyl glycidyl ethers, and acrylate esters. Specific examples include alkyl monoglycidyl ether, alkyl diglycidyl ether, alkyl phenol monoglycidyl ether, and 2-(2-vinyloxyethoxy)ethyl acrylate.

Examples of the method of applying the composition on the substrate include gravure, offset, screen, and other general-purpose printing methods, as well as die coat, slit coat, slit die coat, gravure coat, reverse coat, dipping, inkjet, and spray coating. Examples of the means to dry the composition include ovens and hot plates. In particular, vacuum drying is preferably used to increase drying efficiency.

Examples of the method of preparing the composition for obtaining the film of the present invention includes a method in which a light-blocking coloring agent A, a second coloring agent used as needed, particularly at least one coloring agent selected from the group consisting of a red coloring agent, a yellow coloring agent, and a blue coloring agent, together with a binder and a solvent or a reactive diluent are added and dispersed using a disperser to prepare a pigment dispersion, and then other coloring agents and other components are added and mixed as needed.

When a dispersant is included as an additional component, the dispersant may be added during preparation of the pigment dispersion and stirred and mixed using a disperser. Examples of the disperser include sand mills, ball mills, bead mills, three-roll mills, and attritors. Among them, bead mills are preferred because of their excellent dispersion efficiency.

When the film of the present invention has a thickness of tens of micrometers or more and sufficient rigidity, for example, a thermoplastic resin is selected as a binder, and the content of the binder is set to 80 wt% or more, taking the total weight of the entire film as 100 wt%, the composition is heated to make it in a fluid state, and the film from the resin is formed by extrusion molding with a T-die or calendar molding, etc. without using a substrate.

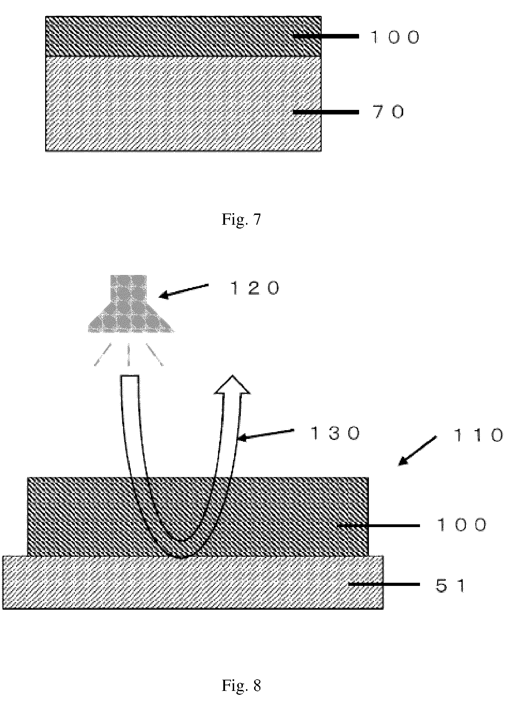

The film can be placed on the surface of various displays 70, such as organic EL, liquid crystal, micro LED, plasma, CRT, laser, etc. (see FIG. 7) to make the colors of the display 70 vivid, improve the durability, and reduce the influence of external light. However, as long as the present invention can achieve its effects and functions whatever the degree is, the present invention is not limited to the mode of use shown in FIG. 7 and can be applied to any product other than this configuration.

For example, the film of the present invention can also be applied to a screen film of an ultra short focus projector. This mode of use will be explained using FIG. 8. A sheet 110 including the film 100 of the present invention formed on an opaque substrate 51 is used as a screen film. The sheet 110 is irradiated with a light beam such as laser from a light source 120 placed on the side of the film 100 of the present invention. The irradiated light passes through the composition and the film 100 of the present invention is reflected at the interface with the opaque substrate 51, and reaches the viewer as the reflected light 130 that has passed through the film 100 of the present invention again, thereby displaying an image.

As a substrate used for the screen film of the ultra short focus projector, a highly reflective opaque substrate 51 is preferred, which contains metal powders such as aluminum, chromium, or nickel, luster pigments, or highly reflective color pigment such as titanium oxide dispersed therein. When the film 100 is thick and has rigidity function as a substrate, a thin metal-deposited film such as aluminum may be formed on the film 100 to provide a sheet 110.

In this case, since the color of the opaque substrate 51 often presents a slight coloration instead of achromatic color, it is preferable to appropriately adjust the type or amount of the coloring agents and, as needed, other components, contained in the film 100 of the present invention, according to the color of the opaque substrate 51, so that with white light incident from a light source, the color of the reflected light 130 becomes achromatic (i.e., white or gray). That is, in the optical device of the present invention utilizing a reflected light, it is desirable that a light source and a sheet having the film of the present invention provided on a substrate be included, and the chromaticity (a*, b*) of the reflected light of the light incident from the light source to the sheet be set to -10 ≤ a* ≤ 10 and -10 ≤ b* ≤ 10.

The chromaticity (a*, b*) in reflected light and chromaticity (a*, b*) in transmitted light of the film are determined by measurement using a "CM3700d" spectrophotometer manufactured by KONICA MINOLTA, INC., in CIE L*a*b* color system mode with a visual field of 2°. When evaluating the chromaticity in reflected light, it is preferable to employ the SCI (Specular Component Included) method, which includes regularly reflected light.

In addition, a D65 light source or a C light source is often used as a light source for the optical device. The sheet of the present invention when a reflected light is used is a sheet in which the film of the present invention is provided on a substrate, and chromaticity (a*, b*) in reflected light according to the SCI method is preferably -10 ≤ a* ≤ 10 and -10 ≤ b* ≤ 10 when measured with a spectrophotometer using a D65 light source as a light source. Also, in a case where the sheet has the film of the present invention provided on the substrate and a light source A is used as the light source, it is desirable for the sheet to have chromaticity (a*, b*) in reflected light according to the SCI method of -10 ≤ a* ≤ 10 and -10 ≤ b* ≤ 10 when measured with a spectrophotometer.

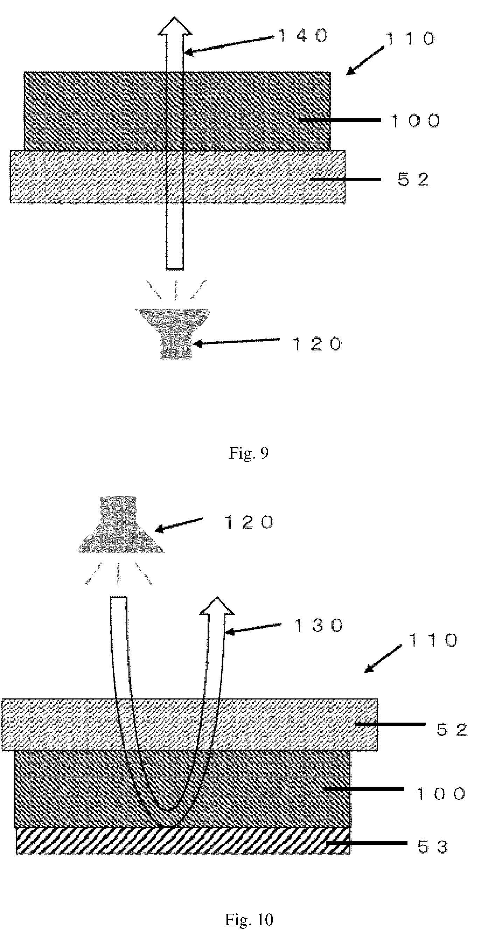

In addition, the film of the present invention can also be applied to the optical device that utilizes the transmitted light, such as organic EL, liquid crystal, and micro LED. This mode of use will be explained using FIG. 9, where a sheet 110 having the film 100 of the present invention formed on a transparent substrate 52 acts as a filter, and a light beam is allowed to enter toward the transparent substrate 52 from a light source 120 placed on the side of the transparent substrate 52. The incident light passes through the transparent substrate 52 and the film 100 of the present invention, and reaches the viewer as a transmitted light 140, thereby displaying an image.

At that time, the color of the transparent substrate 52 may present a slight coloration instead of achromatic color. In such cases, it is preferable to appropriately adjust the type or amount of the coloring agent and, as needed, other components, contained in the film 100 of the present invention, according to the color of the transparent substrate 52, so that when white light is allowed to enter from a light source, the color of the transmitted light 140 becomes achromatic color (i.e., white or gray). That is, in the optical device of the present invention utilizing a transmitted light, it is desirable that a light source and a sheet having the film of the present invention provided on a substrate be included, and the chromaticity (a*, b*) in transmitted light of the light incident from the light source to the sheet be set to - 10 ≤ a* ≤ 10 and -10 ≤ b* ≤ 10. When evaluating the chromaticity in transmitted light, the scattered transmitted light will be included for the measurement.

In addition, a D65 light source or a C light source is often used as a light source for the optical device. The sheet of the present invention when a transmitted light is used is a sheet in which the film of the present invention is provided on a substrate, and chromaticity (a*, b*) in transmitted light according to the SCI method is preferably -10 ≤ a* ≤ 10 and -10 ≤ b* ≤ 10 when measured with a spectrophotometer using a D65 light source as a light source. Also, in a case where the sheet has the film of the present invention provided on the substrate and a light source A is used as the light source, it is desirable for the sheet to have chromaticity (a*, b*) in transmitted light of -10 ≤ a* ≤ 10 and -10 ≤ b* ≤ 10 when measured with a spectrophotometer.

In addition, in a case of the optical device of the present invention, it is also envisaged that the spectrum of the light source is not achromatic color (white), and when such a light source is used, it is preferable to appropriately adjust the type or amount of the coloring agent and, as needed, other components, contained in the film of the present invention, depending on the spectrum of the light source, so that the chromaticity (a*, b*) in reflected light is -10 ≤ a* ≤ 10 and -10 ≤ b* ≤ 10 when the reflected light is used, and that in transmitted light is -10 ≤ a* ≤ 10 and -10 ≤ b* ≤ 10 when the transmitted light is used. In this case, when the color of the opaque substrate or the transparent substrate is not achromatic color, the determination of the color of the film of the present invention is made with further consideration of the above-described explanation of such cases.

The design of the film of the present invention in the optical device of the present invention will be specifically described with examples. First, the chromaticity of the light source used for the actual optical device, that is, light source chromaticity (Δa*₀₁, Δb*₀₁) is calculated. The light source chromaticity is the difference between the chromaticity of the surface of the standard sheet irradiated with the light source used for the actual optical device and the chromaticity of the surface of the standard sheet irradiated with a standard light source. That is, when the difference Δa*₀₁ obtained by subtracting the chromaticity of the surface of the standard sheet irradiated with the standard light source from the chromaticity of the surface of the standard sheet irradiated with the light source used for the actual optical device is positive, the color approaches red, and when Δa*₀₁ is negative, the color approaches green; when Δb*₀₁ is positive, the color approaches yellow, and when Δb*₀₁ is negative, the color approaches blue. The standard light source is a D65 light source. The standard sheet is a sheet such that when irradiated with light from the selected standard light source, the reflected light measured on the surface of the sheet is achromatic white. Light is irradiated onto the standard sheet from the standard light source and the light source used for the actual optical device, and the chromaticity in reflected light on the surface of the standard sheet according to the SCI method is measured with a spectrophotometer.

Next, the chromaticity of the substrate used for the actual optical device, that is, substrate chromaticity is calculated. The substrate used herein refers to a member other than the film of the present invention in the target optical device, which is located in a light path of light from a light source, or from which said light is reflected (in a case of a reflective plate in a reflective optical device), in the target optical device. The chromaticity in reflected light on the surface of the substrate according to the SCI method, i.e., the substrate chromaticity in reflected light (a^{*}₁₁, b*₁₁), or the chromaticity in transmitted light transmitting through the substrate, i.e., the substrate chromaticity in transmitted light (a^{*}₁₂, b^{*}₁₂), when the substrate is irradiated with light from the standard light source described above, is calculated. The substrate chromaticity in reflected light is the difference between the chromaticity on the surface of a substrate to be used for an actual optical device when the substrate is placed on a standard sheet and irradiated with a standard light source from the substrate side, and the chromaticity on the surface of the standard sheet when the standard sheet is irradiated with the standard light source. In other words, when the difference Δa^{*}₁₁, obtained by subtracting the chromaticity on the surface of the standard sheet irradiated with the standard light source from the chromaticity on the surface of the substrate which is on the standard sheet and used for the actual optical device, irradiated with the standard light source, is positive, the color approaches red, and when Δa^{*}₁₁ is negative, the color approaches green; when Δb^{*}₁₁ is positive, the color approaches yellow, and when Δb^{*}₁₁ is negative, the color approaches blue. Similarly, the substrate chromaticity in transmitted light is the difference between the chromaticity in transmitted light when the substrate used for the actual optical device is irradiated with the standard light source and the chromaticity in transmitted light when the transparent substrate is irradiated with the standard light source. In other words, when the difference Δa^{*}₁₂, obtained by subtracting the chromaticity in transmitted light of the transparent substrate, irradiated with the standard light source, from the chromaticity in transmitted light of the substrate used for the actual optical device, irradiated with the standard light source, is positive, the color approaches red, and when Δa^{*}₁₂ is negative, the color approaches green; when Δb^{*}₁₂ is positive, the color approaches yellow, and when Δb^{*}₁₂ is negative, the color approaches blue. The transparent substrate is a substrate with a total light transmittance of 99% or more when measured using the method specified in JIS K 7375:2008.

Next, the chromaticity of the film, that is, film chromaticity is calculated. When a film formed on a standard sheet is irradiated with light from the standard light source, the chromaticity in reflected light on the surface of the film according to the SCI method, that is, the film chromaticity in reflected light (a^{*}₂₁, b^{*}₂₁), or the chromaticity in transmitted light transmitting through the film, that is, the film chromaticity in transmitted light (a^{*}₂₂, b^{*}₂₂) is calculated. The film chromaticity in reflected light is the difference between the chromaticity on the surface of a film when the film formed on the standard sheet is irradiated with a standard light source, and the chromaticity of the surface of the standard sheet when the standard sheet is irradiated with the standard light source. In other words, when the difference Δa^{*}₂₁, obtained by subtracting the chromaticity on the surface of the standard sheet, irradiated with the standard light source, from the chromaticity on the surface of the film formed on the standard sheet, irradiated with the standard light source, is positive, the color approaches red, and when Δa^{*}₂₁ is negative, the color approaches green; when Δb^{*}₂₁ is positive, the color approaches yellow, and when Δb^{*}₂₁ is negative, the color approaches blue. Similarly, the film chromaticity in transmitted light is the difference between the chromaticity in transmitted light when the film formed on the transparent substrate is irradiated with the standard light source and the chromaticity in transmitted light when the transparent substrate is irradiated with the standard light source. In other words, when the difference Δa^{*}₂₂, obtained by subtracting the chromaticity in transmitted light of the transparent substrate, irradiated with the standard light source, from the chromaticity in transmitted light of the film formed on the transparent substrate, irradiated with the standard light source, is positive, the color approaches red, and when Δa^{*}₂₂ is negative, the color approaches green; when Δb^{*}₂₂ is positive, the color approaches yellow, and when Δb^{*}₂₂ is negative, the color approaches blue.

Then, the chromaticity of the film is determined based on these measurements. That is, in a case of reflective optical device, a*₂₁ + a*₁₁ + Δa*₀₁ is calculated as a* of the film that should be equipped, b*₂₁ + b*₁₁ + Δb*₀ is calculated as b* of the film that should be equipped, and in a case of transmissive optical device, a*₂₂ + a*₁₂ + Δa*₀₁ is calculated as a* of the optical device that should be equipped, and b*₂₂ + b*₁₂ + Δb*₀₁ is calculated as b* of the film that should be equipped.

In a case of reflective optical device, the color of the film is set by selecting the type and amount of the coloring agent to be used so that the value of a*₂₁ + a*₁₁ + Δa*₀₁ and the value of b*₂₂ + b*₁₂ + Δb*₀₁ approach zero as possible. In a case of transmissive optical device, the color of the film is set by selecting the type and amount of the coloring agent to be used so that the value of a*₂₂ + a*₁₂ + Δa*₀₁ and the value of b*₂₂ + b*₁₂ + Δb*₀₁ approach zero as possible.

For the selection of the type and amount of such coloring agents, the blending can be calculated by simulation based on a database obtained by measuring the chromaticity of the coloring agents in advance.

Needless to say, in the above measurement, the photoreceiver has to be placed at a position where the measurement described above can achieve its purpose.

The light source used for the optical device of the present invention may be any light source suitable for display. For example, light sources such as A, C, D50, D65, F2, F6, F7, F8, F10, F11, F12, etc. may be used.

### Examples

### (Preparation of compositions 1 to 26)

The coloring agent, dispersant, and solvent shown in tables were mixed to prepare a coloring agent dispersion. To this coloring agent dispersion, a binder resin, a reactive monomer, a polymerization initiator, a surfactant, and a solvent (or a reactive diluent) were added, mixed thoroughly, and then filtered through a filter to obtain the composition, having the composition shown in Tables 1 to 7. In the tables, the meaning of "Component" corresponds to "material" in English.

In each table, IR indicates a coloring agent that is the light-blocking coloring agent A, IRB is C.I. Pigment Black, A1103 is "Chromofine black A1103" manufactured by Dainichiseika Color & Chemicals Mfg. Co., Ltd., and Irgaphor is "Irgaphor Black" manufactured by BASF. In addition, PR is an abbreviation for C.I. Pigment Red, PB is an abbreviation for C.I. Pigment Blue, PY is an abbreviation for C.I. Pigment Yellow, and PV is an abbreviation for C.I. Pigment Violet. CB is carbon black "MA100" manufactured by Mitsubishi Chemical Group Corporation, BZMA is benzyl methacrylate manufactured by Tokyo Chemical Industry Co., Ltd., MAA is methacrylic acid manufactured by MITSUBISHI GAS CHEMICAL COMPANY, INC., BYK167 is DISPERBYK-167 manufactured by BYK Japan KK, DPHA is dipentaerythritol hexaacrylate manufactured by DAICEL-ALLNEX LTD, Omnirad 907 is former Irgacure 907 manufactured by IGM Resins B.V., F477 is F477 manufactured by DIK Corporation, PGMEA is propylene glycol monomethyl ether acetate manufactured by Hayashi Pure Chemical Industries, Ltd., EEP is ethyl 3-ethoxypropionate manufactured by Shinko Organic Chemical Industry Ltd., and YED811 is alkyl monoglycidyl ether-based reactive diluent YED811 manufactured by Mitsubishi Chemical Group Corporation.

### (Preparation of sheets of Examples 1 to 12, Comparative Examples 1 to 11)

Next, the compositions 1 to 12 and the compositions 15 to 24 were applied to the substrate shown in Tables 8 to 11 and Table 13 using a die coater, as shown in each table, and dried in an oven set at 90°C for 10 minutes to disperse and remove solvent. The binder resin was further exposed to a UV irradiation machine to cure the binder resin, resulting in a sheet with a film formed on the surface of the substrate at the thickness shown in each table.

### (Preparation of sheet of Example 13)

The composition 13 was applied on the substrate shown in Table 12 using a lip coater, and exposed to a UV irradiation machine to cure the binder resin, resulting in a sheet with a film formed on the surface of the substrate at the thickness shown in Table 12. In Example 13, a release layer composed of a resin having releasability was applied to the surface of the substrate before the composition was applied, using a gravure coater, and used as a pre-formed substrate. Thus, the film can be released from the substrate.

### (Preparation of film of Example 14)

The composition 14 was placed in a hopper, and heated to a temperature equal to or higher than the melting point of the binder of the composition 14 to melt the composition 14, the molten composition 14 was extruded toward a T-die whose lip opening was controlled so that the thickness of the film was as shown in Table 12, and the molten film was cooled on a cooling roll, the solidified film was taken up and conveyed to a winder to obtain a roll of the film.

### (Measurement of film thickness)

The thickness of the resulting film was measured using a "DektakXT-S" manufactured by Bruker Japan K.K. or a "High-Accuracy Digimatic Micrometer MDH-25MC" manufactured by Mitutoyo Corporation. In Examples 1 to 13 and Comparative Examples 1 to 11, the film was scratched with a diamond cutter to expose the substrate. The thickness of the film was obtained by measuring the difference in height between the surface of the film and the substrate using the "DektakXT-S" manufactured by Bruker Japan K.K. In Example 14, the thickness of the film was measured using a "High-Accuracy Digimatic Micrometer MDH-25MC" manufactured by Mitutoyo Corporation.

### (Measurement of light transmittance)

The light transmittance of the resulting film was measured in the measurement wavelength range from 380 nm to 780 nm, using a microspectrophotometer "LCF-100MA" MCPD9800 spectrometer 3683C manufactured by Otsuka Electronics Co., Ltd., every 1 nm, by setting an exposure time to 30 msec, an accumulation count to 4, sensitivity to Normal, chromaticity (C light source).

The light transmittance of the light-blocking coloring agent A was measured by forming a film on a glass substrate at a film thickness of 1 µm using a transparent acrylic resin (copolymer of benzyl methacrylate/methacrylic acid = 70/30 (molar ratio): weight-average molecular weight in terms of polystyrene of 30,000) as a binder with a concentration of 50 wt%.

Examples 1 to 12 and Comparative Examples 1 to 11 show values from transmission spectra obtained by directly measuring the sheet using each substrate as a reference. In Example 13, alkali-free transparent glass was separately prepared, and a sample for evaluation was prepared by transfer-forming a resin composition layer on the surface of the alkali-free transparent glass using a roll transfer device, and the values obtained from the transmission spectrum measured with the alkali-free transparent glass as a reference are shown. Examples 14 shows values from transmission spectra obtained by measuring the film as it is.

### (Preparation of organic electro-luminescing device)

After a TFT substrate with a bank frame formed thereto was prepared, a buffer film (PEDT: poly(3,4)ethylenedioxythiophene/polystyrene sulfonic acid (trade name: Baytron PCH8000, manufactured by Starck Vitek)) was formed using an inkjet printer at the film thickness equivalent to 0.1 µm. Similarly, an inkjet printer was used to fill the red pixels with red phosphor ink (LUMATION RP-221 (manufactured by SUMATION Co., Ltd.)), the green pixels with green phosphor ink (LUMATION GP-1200 (manufactured by SUMATION Co., Ltd.)), and the blue pixels with blue phosphor ink (LUMATION BP-105 (manufactured by SUMATION Co., Ltd.)), and then the solvent was removed to form phosphor layers. After removing the solvent thoroughly in a vacuum, the charge injection layer (IL40) was filled using an inkjet printer, the solvent was dried and removed, and a high-purity Al-Mg film was formed as a cathode by vapor deposition, then a silicon nitride film was formed by CVD to obtain an organic electro-luminescing device.

### (Attachment of film to surface of organic device)

A transparent ultraviolet-curable resin was applied to the organic electro-luminescing device prepared above using a spin coater, and the sheet or film prepared above was attached facing the organic electro-luminescing device with the ultraviolet-curable resin applied thereto. Next, the ultraviolet-curable resin filled in the gap between the organic electro-luminescing device and the film was irradiated with light to cure, thereby adhesively fixing the sheet or film to the organic electro-luminescing device. For the sheet in Example 13, the substrate was peeled off and removed after attachment.

### (Evaluation of luminance)

From the results of measurements of the light transmittance of the film, the average value T1 (%) of the values of the light transmittance at wavelengths from 400 nm to 660 nm measured every 1 nm was calculated and used as the evaluation index for the luminance: 25% to 90% was designated as A, 0% to less than 25% as B, and more than 90% to less than 100% as C, A being rated as good.

### (Evaluation of color vividness)

From the light transmittance measurement results of the film, the values measured for the light transmittance at 1 nm intervals from 400 nm to 660 nm were used to determine the average value for the light transmittance at wavelengths from 640 nm to 660 nm as T2 (%), the average value for the light transmittance at wavelengths from 580 nm to 620 nm as T3 (%), the average value for the light transmittance at wavelengths from 460 nm to 480 nm as T4 (%), and the average value for the light transmittance at wavelengths from 420 nm to 440 nm as T5 (%). The values of T2 - T3 and T4 - T5 were then calculated and evaluated as follows. A and B are rated as good for color vividness.
A: Both of T2 - T3, and T4 - T5 are 5% or more
B: T2 - T3 is 5% or more, while T4 - T5 is less than 5%
C: T2 - T3 is 3% or more and less than 5%
D: T2 - T3 is 2% or more and less than 3%
E: T2 - T3 is less than 2%

### (Evaluation of color balance)

From the measurement results of the light transmittance of the film, the absolute value of the difference between the maximum value and average value of light transmittance, and the absolute value of the difference between the average value and minimum value of light transmittance (%), at wavelengths of 460 nm, 530 nm, and 640 nm were calculated, and the larger value was determined as a color difference. That is, as the color difference approaches zero, the color approaches neutral tones. The color difference within 3% was designated as A, more than 3% and 6% or less as B, more than 6% and 10% or less as C, and more than 10% as D, with A and B being rated as good.

### (Evaluation of durability)

The prepared sheet or film was used to prepare a sample which was fixed to a pedestal that reciprocated at 2 cm per second, subjected to a sliding tester in which it was pressed with a stainless steel ball having a radius of curvature of 5 mm with a load of 240 g applied thereto, and tested up to 1,000 times in increments of 500 times. This sample was disassembled and the opposing orientation films were observed. The operation in the sliding tester was continued until scratches were observed, and the maximum number of times producing no scratches was regarded as sliding-resistant number. The sliding properties were evaluated according to the following criteria. A is rated as good.
A: Sliding resistant number exceeds 500 times
B: Sliding resistant number is 500 times or less

### (Evaluation of display quality)

An image was displayed in a state where the prepared sheet or film was attached to the organic electro-luminescing device prepared above, and visually observed to evaluate the display quality as follows, with C and higher ranks being rated as good.
A: Neutral and vivid color, with extremely good visibility
B: Inferior to A, with very good visibility
C: Inferior to B, with good visibility
D: Clearly inferior to A, B and C in color balance and color vividness, with poor visibility
E: Very poor visibility or cannot be evaluated.

### (Evaluation results of organic electro-luminescing device including laminated films)

The films of Examples 1 to 14, which contained the light-blocking coloring agent A, had higher pixel vividness for each color compared to the films of Comparative Examples 1 to 11, and the effect was particularly remarkable for red pixels. In addition, each pixel was bright and excellent in visibility.

### (Examples 15 to 18, Comparative Examples 12 to 13)

On a PET film having a thickness of 125 µm with release treatment on one side, a resin composition obtained by mixing titanium dioxide and C.I. Pigment Yellow 129 added to urethane resin dissolved in an organic solvent was applied with a reverse coater so that the thickness after drying by heat drying at 100°C for 2 minutes was 250 µm to form a yellowish-white urethane resin sheet.

Next, the composition 12 (Example 17, Example 18), the composition 18 (Comparative Example 12, Comparative Example 13), the composition 25 (Example 15), and the composition 26 (Example 16) were applied to the yellowish-white urethane resin sheet with a die coater as shown in Table 14, dried in an oven set to 90°C for 10 minutes to disperse and remove the solvent, and exposed to a UV irradiation machine to cure the binder resin, thereby to form a film having a thickness of 10 µm. The PET film was then peeled off to obtain a sheet, measuring 1.2 m in length × 1.8 m in width.

### (Evaluation of chromaticity)

A light beam was irradiated toward the surface of the film from a D65 light source or an A light source, placed at an oblique angle of 30 degrees at a distance of approximately 50 cm from a surface on which the sheet was attached, and the chromaticity (a*, b*) in reflected light in the vicinity of the surface of the film according to the SCI method was measured using a spectrophotometer (CM3700d; manufactured by , KONICA MINOLTA, INC.). The results are shown in Table 14. The color difference with completely achromatic color was calculated according to the calculating formula: SQRT {(Δa^{*})² + (Δb^{*})²} using the difference calculated as Δa^{*} = |a^{*} - a₀^{*}|, Δb^{*} = |b^{*} - b₀^{*}|, where the chromaticity of completely achromatic color is (a^{*}₀ = 0, b^{*}₀ = 0), with A to D being rated as good.
A: Color difference with completely achromatic color is less than 3.0
B: Color difference with completely achromatic color is 3.0 or more and less than 5.0
C: Color difference with completely achromatic color is 5.0 or more and less than 7.5
D: Color difference with completely achromatic color is 7.5 or more and less than 10.0
E: Color difference with completely achromatic color is 10.0 or more.

### (Preparation of screens for ultra short focus projector)

A skirt composed of polyurethane-based elastomer resin was attached to the bottom end of the sheet prepared above, a base provided with a telescopic pole and a shaft and spring for winding the sheet inside was attached, and an aluminum top bar was attached to the top end of the sheet to pull the screen up evenly in the width direction to prepare a screen for an ultra short focus projector.

### (Evaluation results for screens for ultra short focus projector including laminated sheets)

When a projector image was projected onto the screen for the ultra short focus projector using the sheets of Examples 15 and 17 at a distance of approximately 1 m, from a position that was in the center in the horizontal direction and toward the lower part in the vertical direction, the colors of the projector image were reflected more faithfully compared to when a similar projection was performed on the screen for the ultra short focus projector of Comparison Example 12.

In addition, when a projector image with a defect of an overall reddish tint was projected onto the screen for the ultra short focus projector using the sheets of Examples 16 and 18 from a position at a distance of approximately 1 m that was in the center in the horizontal direction and toward the lower part in the vertical direction, the defect of the reddish tint of the projector image was eliminated compared to when a similar projection was performed on the screen for the ultra short focus projector using the sheet of Comparison Example 13.

### [Table 1]

**[Table 1]**

| | | Composition 1 | | Composition 2 | | Composition 3 | | Composition 4 | |
|---|---|---|---|---|---|---|---|---|---|
| | | Component | pts. wt. | Component | pts. wt. | Component | pts. wt. | Component | pts. wt. |
| Coloring agent | IR | IRB | 5.0 | IRB | 7.0 | IRB | 2.5 | IRB | 5.0 |
| | Red | PR220 | 5.0 | PR220 | 4.0 | PR220 | 5.0 | PR220 | 5.0 |
| | Blue | PB15:6 | 5.0 | PB15:6 | 4.0 | PB15:6 | 5.0 | PB 15:6 | 4.0 |
| | Yellow | PÝ150 | 1.0 | PÝ150 | - | PÝ150 | 2.5 | PÝ150 | 1.0 |
| | Violet | - | - | PV19 | 1.0 | PV19 | 1.0 | PV19 | 1.0 |
| | Others | - | - | - | - | - | - | - | - |
| Binder | | BZMA | 40 | BZMA | 40 | BZMA | 40 | BYK167 | 40 |
| | | MAA | 21 | MAA | 21 | MAA | 21 | MAA | 21 |
| Dispersant | | BYK167 | 7 | BYK167 | 7 | BYK167 | 7 | BYK167 | 7 |
| Reactive monomer | | DPHA | 8 | DPHA | 8 | DPHA | 8 | DPHA | 8 |
| Polymerization initiator | | Omnirad 907 | 2 | Omnirad 907 | 2 | Omnirad 907 | 2 | Omnirad 907 | 2 |
| Surfactant | | F477 | 2 | F477 | 2 | F477 | 2 | F477 | 2 |
| Solvent | | PGMEA | 200 | PGMEA | 200 | PGMEA | 200 | PGMEA | 200 |
| | | EEP | 120 | EEP | 120 | EEP | 120 | EEP | 120 |

### [Table 2]

**[Table 2]**

| | | Composition 5 | | Composition 6 | | Composition 7 | | Composition 8 | |
|---|---|---|---|---|---|---|---|---|---|
| | | Component | pts. wt. | Component | pts. wt. | Component | pts. wt. | Component | pts. wt. |
| Coloring agent | IR | A1103 | 5.0 | A1103 | 7.0 | A1103 | 2.5 | A1103 | 5.0 |
| | Red | PR220 | 5.0 | PR220 | 4.0 | PR220 | 5.0 | PR220 | 5.0 |
| | Blue | PB15:6 | 5.0 | PB15:6 | 4.0 | PB15:6 | 5.0 | PB15:6 | 4.0 |
| | Yellow | PÝ150 | 1.0 | PÝ150 | - | PÝ150 | 2.5 | PÝ150 | 1.0 |
| | Violet | - | - | PV19 | 1.0 | PV19 | 1.0 | PV19 | 1.0 |
| | Others | - | - | - | - | - | - | - | - |
| Binder | | BZMA | 40 | BZMA | 40 | BZMA | 40 | BZMA | 40 |
| | | MAA | 21 | MAA | 21 | MAA | 21 | MAA | 21 |
| Dispersant | | BYK167 | 7 | BYK167 | 7 | BYK167 | 7 | BYK167 | 7 |
| Reactive monomer | | DPHA | 8 | DPHA | 8 | DPHA | 8 | DPHA | 8 |
| Polymerization initiator | | Omnirad 907 | 2 | Omnirad 907 | 2 | Omnirad 907 | 2 | Omnirad 907 | 2 |
| Surfactant | | F477 | 2 | F477 | 2 | F477 | 2 | F477 | 2 |
| Solvent | | PGMEA | 200 | PGMEA | 200 | PGMEA | 200 | PGMEA | 200 |
| | | EEP | 120 | EEP | 120 | EEP | 120 | EEP | 120 |

### [Table 3]

**[Table 3]**

| | | Composition 9 | | Composition 10 | | Composition 11 | | Composition 12 | |
|---|---|---|---|---|---|---|---|---|---|
| | | Component | pts. wt. | Component | pts. wt. | Component | pts. wt. | Component | pts. wt. |
| Coloring agent | IR | Irgaphor | 5.0 | Irgaphor | 7.0 | Irgaphor | 2.5 | Irgaphor | 5.0 |
| | Red | PR220 | 5.0 | PR220 | 4.0 | PR220 | 5.0 | PR220 | 5.0 |
| | Blue | PB15:6 | 5.0 | PB15:6 | 4.0 | PB15:6 | 5.0 | PB 15:6 | 4.0 |
| | Yellow | PÝ150 | 1.0 | PÝ150 | - | PÝ150 | 2.5 | PÝ150 | 1.0 |
| | Violet | - | - | PV19 | 1.0 | PV19 | 1.0 | PV19 | 1.0 |
| | Others | - | - | - | - | - | - | - | - |
| Binder | | BZMA | 40 | BZMA | 40 | BZMA | 40 | BZMA | 40 |
| | | MAA | 21 | MAA | 21 | MAA | 21 | MAA | 21 |
| Dispersant | | BYK167 | 7 | BYK167 | 7 | BYK167 | 7 | BYK167 | 7 |
| Reactive monomer | | DPHA | 8 | DPHA | 8 | DPHA | 8 | DPHA | 8 |
| Polymerization initiator | | Omnirad 907 | 2 | Omnirad 907 | 2 | Omnirad 907 | 2 | Omnirad 907 | 2 |
| Surfactant | | F477 | 2 | F477 | 2 | F477 | 2 | F477 | 2 |
| Solvent | | PGMEA | 200 | PGMEA | 200 | PGMEA | 200 | PGMEA | 200 |
| | | EEP | 120 | EEP | 120 | EEP | 120 | EEP | 120 |

**[Table 4]**

| | | Composition 13 | | Composition 14 | |
|---|---|---|---|---|---|
| | | Component | pts. wt. | Component | pts. wt. |
| Coloring agent | IR | Irgaphor | 5.0 | Irgaphor | 5.0 |
| | Red | PR220 | 5.0 | PR220 | 5.0 |
| | Blue | PB15:6 | 4.0 | PB15:6 | 4.0 |
| | Yellow | PÝ150 | 1.0 | PÝ150 | 1.0 |
| | Violet | PV19 | 1.0 | PV19 | 1.0 |
| | Others | - | - | - | - |
| Binder | | BZMA | 2000 | BZMA | 20000 |
| | | MAA | 1050 | MAA | 10500 |
| Dispersant | | BYK167 | 70 | BYK167 | 300 |
| Reactive monomer | | DPHA | 400 | DPHA | 4000 |
| Polymerization initiator | | Omnirad 907 | 100 | Omnirad 907 | 1000 |
| Surfactant | | F477 | 100 | F477 | 1000 |
| Reactive diluent | | YED811 | 280 | YED811 | 3200 |

### [Table 5]

**[Table 5]**

| | | Composition 15 | | Composition 16 | | Composition 17 | | Composition 18 | |
|---|---|---|---|---|---|---|---|---|---|
| | | Component | pts. wt. | Component | pts. wt. | Component | pts. wt. | Component | pts. wt. |
| Coloring agent | IR | - | - | - | - | - | - | - | - |
| | Red | PR220 | 5.0 | PR220 | 4.0 | PR220 | 5.0 | PR220 | 5.0 |
| | Blue | PB15:6 | 5.0 | PB15:6 | 4.0 | PB15:6 | 5.0 | PB15:6 | 5.0 |
| | Yellow | PÝ150 | 1.0 | PÝ150 | - | PÝ150 | 2.5 | PÝ150 | 0.5 |
| | Violet | - | - | PV19 | 1.0 | PV19 | 1.0 | PV19 | 0.5 |
| | Others | - | - | - | - | - | - | - | - |
| Binder | | BZMA | 40 | BZMA | 40 | BZMA | 40 | BZMA | 40 |
| | | MAA | 21 | MAA | 21 | MAA | 21 | MAA | 21 |
| Dispersant | | BYK167 | 7 | BYK167 | 7 | BYK167 | 7 | BYK167 | 7 |
| Reactive monomer | | DPHA | 8 | DPHA | 8 | DPHA | 8 | DPHA | 8 |
| Polymerization initiator | | Omnirad 907 | 2 | Omnirad 907 | 2 | Omnirad 907 | 2 | Omnirad 907 | 2 |
| Surfactant | | F477 | 2 | F477 | 2 | F477 | 2 | F477 | 2 |
| Solvent | | PGMEA | 200 | PGMEA | 200 | PGMEA | 200 | PGMEA | 200 |
| | | EEP | 120 | EEP | 120 | EEP | 120 | EEP | 120 |

### [Table 6]

**[Table 6]**

| | | Composition 19 | | Composition 20 | | Composition 21 | | Composition 22 | |
|---|---|---|---|---|---|---|---|---|---|
| | | Component | pts. wt. | Component | pts. wt. | Component | pts. wt. | Component | pts. wt. |
| Coloring agent | IR | - | - | - | - | - | - | - | - |
| | Red | PR220 | 5.0 | PR220 | 4.0 | PR220 | 5.0 | PR220 | 5.0 |
| | Blue | PB15:6 | 5.0 | PB15:6 | 4.0 | PB15:6 | 5.0 | PB15:6 | 5.0 |
| | Yellow | PÝ150 | 1.0 | PÝ150 | - | PÝ150 | 2.5 | PÝ150 | 0.5 |
| | Violet | - | - | PV19 | 1.0 | PV19 | 1.0 | PV19 | 0.5 |
| | Others | CB | 5 | CB | 7 | CB | 3 | CB | 5 |
| Binder | | BZMA | 40 | BZMA | 40 | BZMA | 40 | BZMA | 40 |
| | | MAA | 21 | MAA | 21 | MAA | 21 | MAA | 21 |
| Dispersant | | BYK167 | 7 | BYK167 | 7 | BYK167 | 7 | BYK167 | 7 |
| Reactive monomer | | DPHA | 8 | DPHA | 8 | DPHA | 8 | DPHA | 8 |
| Polymerization initiator | | Omnirad 907 | 2 | Omnirad 907 | 2 | Omnirad 907 | 2 | Omnirad 907 | 2 |
| Surfactant | | F477 | 2 | F477 | 2 | F477 | 2 | F477 | 2 |
| Solvent | | PGMEA | 200 | PGMEA | 200 | PGMEA | 200 | PGMEA | 200 |
| | | EEP | 120 | EEP | 120 | EEP | 120 | EEP | 120 |

### [Table 7]

**[Table 7]**

| | | Composition 23 | | Composition 24 | | Composition 25 | | Composition 26 | |
|---|---|---|---|---|---|---|---|---|---|
| | | Component | pts. wt. | Component | pts. wt. | Component | pts. wt. | Component | pts. wt. |
| Coloring agent | IR | IRB | 0.5 | IRB | 85.0 | Irgaphor | 5.0 | Irgaphor | 5.0 |
| | Red | PR220 | 0.5 | PR220 | 2.0 | PR220 | 5.0 | PR220 | 3.0 |
| | Blue | PB15:6 | 0.4 | PB15:6 | 2.0 | PB15:6 | 4.8 | PB 15:6 | 7.3 |
| | Yellow | PÝ150 | 0.1 | PÝ150 | 0.5 | PÝ150 | 0.2 | PÝ150 | 0.2 |
| | Violet | PV19 | 0.1 | PV19 | 0.5 | PV19 | 1.0 | PV19 | 0.5 |
| | Others | - | - | - | - | - | - | - | - |
| Binder | | BZMA | 40 | BZMA | 40 | BZMA | 40 | BZMA | 40 |
| | | MAA | 21 | MAA | 21 | MAA | 21 | MAA | 21 |
| Dispersant | | BYK167 | 7 | BYK167 | 7 | BYK167 | 7 | BYK167 | 7 |
| Reactive monomer | | DPHA | 8 | DPHA | 8 | DPHA | 8 | DPHA | 8 |
| Polymerization initiator | | Omnirad 907 | 2 | Omnirad 907 | 2 | Omnirad 907 | 2 | Omnirad 907 | 2 |
| Surfactant | | F477 | 2 | F477 | 2 | F477 | 2 | F477 | 2 |
| Solvent | | PGMEA | 200 | PGMEA | 200 | PGMEA | 200 | PGMEA | 200 |
| | | EEP | 120 | EEP | 120 | EEP | 120 | EEP | 120 |

### [Table 8]

**[Table 8]**

| | | Example 1 | Example 2 | Example 3 | Comparative Example 1 | Comparative Example 2 |
|---|---|---|---|---|---|---|
| Substrate | | Toray Lumirror^{™} T60 | Toray Lumirror^{™} T60 | Toray Lumirror^{™} T60 | Toray Lumirror^{™} T60 | Toray Lumirror^{™} T60 |
| | | 125 µm transparent PET film | 125 µm transparent PET film | 125 µm transparent PET film | 125 µm transparent PET film | 125 µm transparent PET film |
| Composition | | Composition 1 | Composition 5 | Composition 9 | Composition 15 | Composition 19 |
| Film thickness(µm) | | 0.4 | 0.4 | 0.4 | 0.4 | 0.4 |
| T1(%) | | 50 | 51 | 49 | 58 | 43 |
| T2(%) | | 52 | 53 | 51 | 67 | 52 |
| T3(%) | | 49 | 50 | 48 | 66 | 50 |
| T4(%) | | 51 | 52 | 50 | 57 | 42 |
| T5(%) | | 48 | 49 | 47 | 56 | 40 |
| T2-T3(%) | | 3 | 3 | 3 | 1 | 2 |
| T4-T5(%) | | 3 | 3 | 3 | 1 | 2 |
| Color difference (%) | | 5 | 5 | 5 | 12 | 11 |
| Evaluation item | Luminance | A | A | A | A | A |
| | Color vividness | C | C | C | E | D |
| | Color balance | B | B | B | D | D |
| | Durability | A | A | A | A | A |
| | Display quality | C | C | C | D | D |

### [Table 9]

**[Table 9]**

| | | Example 4 | Example 5 | Example 6 | Comparative Example 3 | Comparative Example 4 |
|---|---|---|---|---|---|---|
| Substrate | | Toray Lumirror^{™} T60 | Toray Lumirror^{™} T60 | Toray Lumirror^{™} T60 | Toray Lumirror^{™} T60 | Toray Lumirror^{™} T60 |
| | | 125 µm transparent PET film | 125 µm transparent PET film | 125 µm transparent PET film | 125 µm transparent PET film | 125 µm transparent PET film |
| Composition | | Composition 2 | Composition 6 | Composition 10 | Composition 16 | Composition 20 |
| Film thickness(µm) | | 0.4 | 0.4 | 0.4 | 0.4 | 0.4 |
| T1(%) | | 45 | 46 | 44 | 53 | 38 |
| T2(%) | | 47 | 48 | 46 | 62 | 47 |
| T3(%) | | 43 | 44 | 42 | 61 | 45 |
| T4(%) | | 46 | 47 | 45 | 52 | 37 |
| T5(%) | | 42 | 43 | 41 | 51 | 35 |
| T2-T3(%) | | 4 | 4 | 4 | 1 | 2 |
| T4-T5(%) | | 4 | 4 | 4 | 1 | 2 |
| Color difference (%) | | 3 | 3 | 3 | 9 | 8 |
| Evaluation item | Luminance | A | A | A | A | A |
| | Color vividness | C | C | C | E | D |
| | Color balance | A | A | A | C | C |
| | Durability | A | A | A | A | A |
| | Display quality | B | B | B | D | D |

### [Table 10]

**[Table 10]**

| | | Example 7 | Example 8 | Example 9 | Comparative Example 5 | Comparative Example 6 |
|---|---|---|---|---|---|---|
| Substrate | | Toray Lumirror^{™} T60 | Toray Lumirror^{™} T60 | Toray Lumirror^{™} T60 | Toray Lumirror^{™} T60 | Toray Lumirror^{™} T60 |
| | | 125 µm transparent PET film | 125 µm transparent PET film | 125 µm transparent PET film | 125 µm transparent PET film | 125 µm transparent PET film |
| Composition | | Composition 3 | Composition 7 | Composition 11 | Composition 17 | Composition 21 |
| Film thickness(µm) | | 0.4 | 0.4 | 0.4 | 0.4 | 0.4 |
| T1(%) | | 55 | 56 | 54 | 63 | 48 |
| T2(%) | | 58 | 59 | 57 | 72 | 57 |
| T3(%) | | 52 | 53 | 51 | 71 | 55 |
| T4(%) | | 57 | 58 | 56 | 62 | 47 |
| T5(%) | | 53 | 54 | 52 | 61 | 45 |
| T2-T3(%) | | 6 | 6 | 6 | 1 | 2 |
| T4-T5(%) | | 4 | 4 | 4 | 1 | 2 |
| Color difference (%) | | 2 | 2 | 2 | 8 | 7 |
| Evaluation item | Luminance | A | A | A | A | A |
| | Color vividness | B | B | B | E | D |
| | Color balance | A | A | A | C | C |
| | Durability | A | A | A | A | A |
| | Display quality | B | B | B | D | D |

### [Table 11]

**[Table 11]**

| | | Example 10 | Example 11 | Example 12 | Comparative Example 7 | Comparative Example 8 |
|---|---|---|---|---|---|---|
| Substrate | | Toray Lumirror^{™} T60 125 µm transparent PET film | Toray Lumirror^{™} T60 125 µm transparent PET film | Toray Lumirror^{™} T60 125 µm transparent PET film | Toray Lumirror^{™} T60 125 µm transparent PET film | Toray Lumirror^{™} T60 125 µm transparent PET film |
| Composition | | Composition 4 | Composition 8 | Composition 12 | Composition 18 | Composition 22 |
| Film thickness(µm) | | 0.4 | 0.4 | 0.4 | 0.4 | 0.4 |
| T1(%) | | 50 | 51 | 49 | 58 | 43 |
| T2(%) | | 55 | 56 | 54 | 67 | 52 |
| T3(%) | | 45 | 46 | 44 | 66 | 50 |
| T4(%) | | 55 | 56 | 54 | 57 | 42 |
| T5(%) | | 46 | 47 | 45 | 56 | 40 |
| T2-T3(%) | | 10 | 10 | 10 | 1 | 2 |
| T4-T5(%) | | 9 | 9 | 9 | 1 | 2 |
| Color difference (%) | | 1 | 1 | 1 | 8 | 7 |
| Evaluation item | Luminance | A | A | A | A | A |
| | Color vividness | A | A | A | E | D |
| | Color balance | A | A | A | C | C |
| | Durability | A | A | A | A | A |
| | Display quality | A | A | A | D | D |

**[Table 12]**

| | | Example 13 | Example 14 |
|---|---|---|---|
| Substrate | | Toray Lumirror^{™} X10S with release layer 125 µm white PET film | - |
| Composition | | Composition 13 | Composition 14 |
| Film thickness(µm) | | 10 | 200 |
| T1(%) | | 44 | 34 |
| T2(%) | | 48 | 37 |
| T3(%) | | 41 | 31 |
| T4(%) | | 47 | 36 |
| T5(%) | | 41 | 31 |
| T2-T3(%) | | 7 | 6 |
| T4-T5(%) | | 6 | 5 |
| Color difference (%) | | 3 | 3 |
| Evaluation item | Luminance | A | A |
| | Color vividness | A | A |
| | Color balance | A | A |
| | Durability | A | A |
| | Display quality | A | A |

### [Table 13]

**[Table 13]**

| | | Comparative Example 9 | Comparative Example 10 | Comparative Example 11 |
|---|---|---|---|---|
| Substrate | | Toray Lumirror^{™} T60 125 µm transparent PET film | Toray Lumirror^{™} T60 125 µm transparent PET film | Toray Lumirror^{™} T60 125 µm transparent PET film |
| Composition | | Composition 23 | Composition 24 | Composition 4 |
| Film thickness(µm) | | 0.4 | 0.4 | 0.1 |
| T1(%) | | 95 | 10 | 94 |
| T2(%) | | 96 | 11 | 95 |
| T3(%) | | 95 | 10 | 94 |
| T4(%) | | 94 | 9 | 93 |
| T5(%) | | 93 | 8 | 92 |
| T2-T3(%) | | 1 | 1 | 1 |
| T4-T5(%) | | 1 | 1 | 1 |
| Color difference (%) | | 3 | 2 | 3 |
| Evaluation item | Luminance | C | B | C |
| | Color vividness | D | D | D |
| | Color balance | A | A | A |
| | Durability | A | A | B |
| | Display quality | D | D | E |

### [Table 14]

**[Table 14]**

| | | Example 15 | Example 16 | Example 17 | Example 18 | Comparative Example 12 | Comparative Example 13 |
|---|---|---|---|---|---|---|---|
| Composition | | Composition 25 | Composition 26 | Composition 12 | Composition 12 | Composition 18 | Composition 18 |
| Chromaticity | Light source | D65 light source | A light source | D65 light source | A light source | D65 light source | A light source |
| | a* | 0.5 | 2.0 | 2.5 | 5.5 | 7 | 13 |
| | b* | 0.5 | 3 | 6 | 7 | 12 | 15 |
| Color difference with completely achromatic color | | 0.7 | 3.6 | 6.5 | 8.9 | 13.9 | 19.8 |
| Evaluation of chromaticity | | A | B | C | D | E | E |

### Reference Signs List

- 1: Light-blocking coloring agent A
- 2: Red coloring agent
- 3: Yellow coloring agent
- 4: Blue coloring agent
- 5: Violet coloring agent
- 10: Binder
- 50: Substrate
- 51: Opaque substrate
- 52: Transparent substrate
- 53: Reflection film
- 60: Another layer
- 70: Display
- 100: Film
- 110: Sheet
- 120: Light source
- 130: Reflected light
- 140: Transmitted light

## Claims

1. A film having a thickness of 0.2 µm to 1,000 µm, comprising a composition containing:
a coloring agent (hereinafter referred to as a "light-blocking coloring agent A") **characterized in that**, when a film is formed on a glass substrate in a film thickness of 1 µm using transparent acrylic resin as a binder and at coloring agent concentration of 50% by weight, the average light transmittance of the film in the wavelength range of 660 nm to 1000 nm is 30% or more and the average light transmittance of the film in the wavelength range of 380 nm or more and less than 660 nm is 20% or less;
a red coloring agent; and
a binder,
wherein the film has T1 (%) of 25% to 90%, where T1 (%) is an average value of light transmittance at wavelengths from 400 nm to 660 nm.

2. The film according to claim 1, further comprising a coloring agent having an absorption in a visible light region (hereinafter referred to as a "second coloring agent") as a coloring agent that does not fall under the light-blocking coloring agent A and red pigment.

3. The film according to claim 2, wherein the second coloring agent is at least one selected from the group consisting of a yellow coloring agent and a blue coloring agent.

4. The film according to claim 3, wherein the film contains both the yellow coloring agent and the blue coloring agent as the second coloring agent.

5. The film according to any one of claims 1 to 4, wherein all or part of the light-blocking coloring agent A is a compound selected from the group consisting of azomethine compounds, perylene compounds, bisbenzofuranone compounds, and azo compounds.

6. The film according to any one of claims 1 to 5, wherein a content of the light-blocking coloring agent A is 15 wt% to 44 wt%, taking the total amount of the coloring agents contained in the film as 100 wt%.

7. The film according to any one of claims 1 to 6, further comprising a violet coloring agent.

8. The film according to claim 7, wherein a content of the violet coloring agent is 1 wt% to 10 wt%, taking the total amount of the coloring agents contained in the film as 100 wt%.

9. The film according to any one of claims 1 to 8, wherein T2 - T3 is 3% or more, where T2 (%) is an average value of light transmittance at wavelengths from 640 nm to 660 nm, and T3 (%) is an average value of light transmittance at wavelengths from 580 nm to 620 nm.

10. The film according to any one of claims 1 to 9, wherein T4 - T5 is 3% or more, where T4 (%) is an average value of light transmittance at wavelengths from 460 nm to 480 nm, and T5 (%) is an average value of light transmittance at wavelengths from 420 nm to 440 nm.

11. The film according to any one of claims 1 to 10, wherein a color difference is within 6%, where the color difference is defined as the larger one, of the absolute value of the difference between the maximum value and average value of light transmittance, and the absolute value of the difference between the average value and minimum value of light transmittance, at wavelengths of 460 nm, 530 nm, and 640 nm.

12. The film according to any one of claims 1 to 11, wherein the film has adhesiveness.

13. A sheet comprising a substrate, and the film according to any one of claims 1 to 12.

14. The sheet according to claim 13, wherein chromaticity (a*, b*) of a reflected light or transmitted light according to the SCI method when measured using a D65 light source as a light source is -10 ≤ a* ≤ 10 and -10 ≤ b* ≤ 10.

15. The sheet according to claim 13, wherein chromaticity (a*, b*) of a reflected light or transmitted light according to the SCI method when measured using an A light source as a light source is -10 ≤ a* ≤ 10 and -10 ≤ b* ≤ 10.

16. An optical device comprising a light source, and a sheet having the film according to any one of claims 1 to 12 provided on a substrate, wherein the chromaticity (a*, b*) of transmitted light or reflected light of light incident from the light source toward the sheet is -10 ≤ a* ≤ 10 and -10 ≤ b* ≤ 10.
